(19) Europäisches Patentamt
European Patent Office
Office européen des brevets

(11) EP 2 141 187 A1

(12) **EUROPEAN PATENT APPLICATION**
published in accordance with Art. 153(4) EPC

(43) Date of publication:
**06.01.2010 Bulletin 2010/01**

(21) Application number: **08739536.4**

(22) Date of filing: **31.03.2008**

(51) Int Cl.:
***C08G 73/10*** *(2006.01)* ***B65G 15/30*** *(2006.01)*
***G03G 15/16*** *(2006.01)* ***G03G 15/20*** *(2006.01)*
***H01L 23/29*** *(2006.01)* ***H01L 23/31*** *(2006.01)*

(86) International application number:
**PCT/JP2008/056423**

(87) International publication number:
**WO 2008/120787 (09.10.2008 Gazette 2008/41)**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **29.03.2007 JP 2007088563**

(71) Applicant: **Ube Industries, Ltd.**
**Ube-shi**
**Yamaguchi 755-8633 (JP)**

(72) Inventors:
- **YAMAGUCHI, Hiroaki**
  **Ube-shi**
  **Yamaguchi 755-8633 (JP)**
- **TAKABAYASHI, Seiichirou**
  **Ube-shi**
  **Yamaguchi 755-8633 (JP)**
- **MURAKAMI, Tooru**
  **Ube-shi**
  **Yamaguchi 755-8633 (JP)**
- **NAKAYAMA, Takeshige**
  **Ube-shi**
  **Yamaguchi 755-8633 (JP)**

(74) Representative: **Perin, Georges**
**Cabinet Plasseraud**
**52 rue de la Victoire**
**75440 Paris Cedex 09 (FR)**

(54) **AROMATIC POLYIMIDE AND PROCESS FOR PRODUCTION THEREOF**

(57) Disclosed is an aromatic polyimide having extremely high stiffness and extremely high gas barrier property, which is prepared from a tetracarboxylic acid component consisting essentially of 25 mol% to 97 mol% of 3,3',4,4'-biphenyltetracarboxylic acid and 75 mol% to 3 mol% of 4,4'-oxydiphthalic acid based on 100 mol% of the total amount of the tetracarboxylic acid component, and a diamine component consisting essentially of p-phenylenediamine.

EP 2 141 187 A1

## Description

### Technical Field

The present invention relates to an aromatic polyimide of the specific chemical composition which has extremely high stiffness and extremely high gas barrier property, and a process for producing the aromatic polyimide. The aromatic polyimide may be suitably used as a member of electrical and electronic devices, photocopiers, and the like which requires having higher stiffness, or a material for films, hollow beads, and the like which requires having extremely high gas barrier property.

### Background Art

The aromatic polyimide has excellent properties such as heat resistance, chemical resistance, electrical properties, and mechanical properties, and therefore it has been suitably used for electrical and electronic parts, and the like. The aromatic polyimide film prepared from 3,3',4,4'-biphenyltetracarboxylic dianhydride and p-phenylenediamine, in particular, has been suitably used for a flexible substrate for TAB, a fixing belt of a photocopier, and the like, which require dimensional stability and mechanical strength, due to its low linear expansion coefficient and high mechanical strength.

Patent Document 1 discloses an aromatic polyimide having improved long-term durability as compared to a conventional seamless belt prepared from 3,3',4,4'-biphenyltetracarboxylic dianhydride and p-phenylenediamine, in response to higher speed rotation of a seamless tube which is a rotational motion transmission member of various precision instruments such as electrical and electronic devices, electronic photocopiers, and the like. The aromatic polyimide comprises 3,4'-diaminodiphenyl ether in an amount of preferably 5 mol% or more, particularly preferably from 20 mol% to 80 mol%, as a diamine component, and has low strength at break.

Patent Document 2 discloses a polyimide film with gas barrier property in order to solve the problem of deterioration of a metal layer laminated on a polyimide film by oxygen and/or moisture passing through the polyimide film in a step of heating it to a high temperature, such as a step of mounting a chip on it, and thereby a remarkable decrease in peeling strength between the polyimide film and the metal layer. The polyimide film with gas barrier property has a SiOx layer having gas barrier property formed on one side of the polyimide film.

Patent Document 3 discloses a polyimide copolymer which is prepared from 4,4'-oxydiphthalic dianhydride (ODPA) and 3,4,3',4'-biphenyltetracarboxylic dianhydride (s-BPDA), and 4,4'-oxydianiline (ODA) or p-phenylenediamine as a polyimide to be used as an insulating material. In Example 6, a polyimide prepared from p-phenylenediamine, and s-BPDA and ODPA (s-BPDA: 75%, ODPA: 25%) is disclosed. However, the polyimide is produced when using a phthalic acid as an end-capping agent, and conducting the heat treatment for imidization at the highest heating temperature of 300°C. The polyimide does not have sufficient physical properties.

Patent Documents 4 and 5 disclose a process for producing an aromatic polyimide film prepared from 3,3', 4,4'-biphenyltetracarboxylic dianhydride and p-phenylenediamine which is used for a fixing belt of a photocopier.

Furthermore, Patent Document 6 discloses a method for raising the pressure in a hollow part of a resin hollow particle with which a tire air chamber is filled.

Patent Document 1: Japanese Laid-open Patent Publication No. 2006-307114
Patent Document 2: Japanese Laid-open Patent Publication No. 2004-255845
Patent Document 3: Japanese Laid-open Patent Publication No. 1991-157428
Patent Document 4: Japanese Laid-open Patent Publication No. 2003-89125
Patent Document 5: Japanese Laid-open Patent Publication No. 2007-240845
Patent Document 6: Japanese Laid-open Patent Publication No. 2007-69818

### Disclosure of the Invention

### Problems to be Solved by the Invention

The present invention is the fruits of various studies to meet the severer requirements for an aromatic polyimide as described above. An objective of the present invention is to provide an aromatic polyimide of the specific chemical composition which has extremely high stiffness and extremely high gas barrier property, and a process for producing the aromatic polyimide.

Means for Solving the Problems

The present invention relates to the following items.

[1] An aromatic polyimide having a tensile strength at break of 400 MPa or higher and a tensile elongation at break of 35 % or higher in the form of a film, and comprising a repeating unit represented by the following general formula (1):

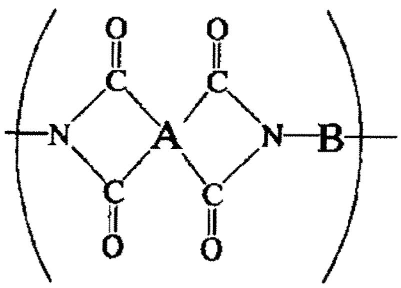

General Formula (1)

wherein 25 mol% to 97 mol% of A is a tetravalent unit represented by the following general formula (2) and 75 mol% to 3 mol% of A is a tetravalent unit represented by the following general formula (3); and B is a bivalent unit represented by the following general formula (4).

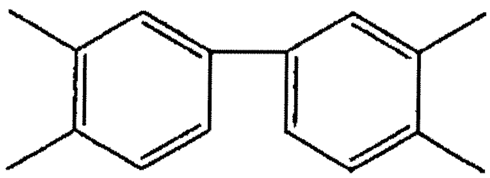

General Formula (2)

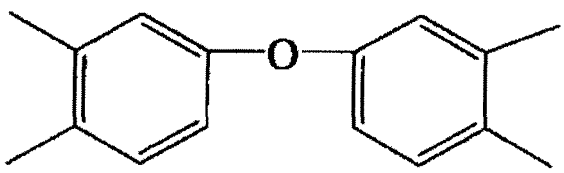

General Formula (3)

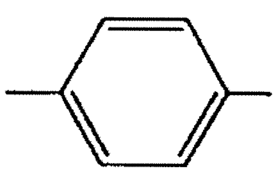

General Formula (4)

[2] The aromatic polyimide according to the above item [1], having a tensile strength at break of 500 MPa or higher and a tensile elongation at break of 40 % or higher in the form of a film.

[3] The aromatic polyimide according to any of the above items [1] to [2], having a tensile energy at break of

145 $MJ/m^3$ or higher in the form of a film.

[4] The aromatic polyimide according to any of the above items [1] to [3], having gas barrier property, i.e., water vapor permeability (40˚C, 90%RH) of 0.04 $g·mm/m^2$ ·24hr or less in the form of a film.

[5] A process for producing an aromatic polyimide, comprising a step of:

heating an aromatic polyamic acid comprising a repeating unit represented by the following general formula (5) at a temperature of 325˚C or higher,

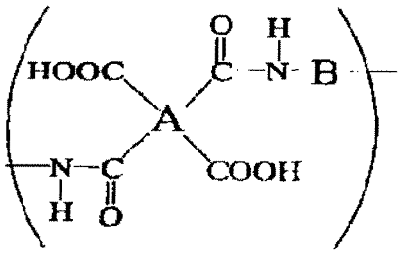

General Formula (5)

wherein 25 mol% to 97 mol% of A is a tetravalent unit represented by the above general formula (2) and 75 mol% to 3 mol% of A is a tetravalent unit represented by the above general formula (3); and B is a bivalent unit represented by the above general formula (4).

[6] A solution composition obtained by dissolving an aromatic polyamic acid comprising a repeating unit represented by the above general formula (5) in an organic solvent.

[7] A seamless belt composed mainly of an aromatic polyimide according to any of the above items [1] to [3].

[8] The seamless belt according to the above item [7], which is used as an intermediate transfer seamless belt, a fixing seamless belt, or a conveying seamless belt of an electrophotographic device.

[9] A packaging material or a sealing material composed mainly of an aromatic polyimide according to the above item [4].

[10] A polyimide hollow bead composed mainly of an aromatic polyimide according to the above item [4].

[11] The polyimide hollow bead according to the above item [10], which is filled with a high pressure gas.

[12] The polyimide hollow bead according to the above item [10], which is filled with nitrogen gas.

## Effect of the Invention

According to the present invention, there may be provided an aromatic polyimide of the specific chemical composition which has extremely high stiffness and extremely high gas barrier property, and a process for producing the aromatic polyimide.

The aromatic polyimide of the present invention comprises a constituent unit (general formula (2)) derived from 3,3',4,4'-biphenyltetracarboxylic acid, a constituent unit (general formula (3)) derived from 4,4'-oxydiphthalic acid, and a constituent unit (general formula (4)) derived from p-phenylenediamine, and it comprises the constituent unit derived from 4,4'-oxydiphthalic acid in the range of 75 mol% to 3 mol% based on 100 mol% of the total amount of the tetracarboxylic acid component (3,3',4,4'-biphenyltetracarboxylic acid and 4,4'-oxydiphthalic acid). Consequently, it may have improved stiffness and gas barrier property. In addition, according to the present invention, the heating temperature for imidization is preferably 325˚C or higher, particularly preferably 350˚C or higher. When conducting the heat treatment at such a high temperature, the polyimide having excellent properties as described above may be obtained. The heating temperature is preferably 500˚C or lower, particularly preferably 450˚C or lower.

The aromatic polyimide of the present invention has extremely high stiffness, and therefore it may be suitably used for parts for various precision instruments such as electrical and electronic devices, and photocopiers, for example, an intermediate transfer seamless belt, a fixing seamless belt, or a conveying seamless belt of an electrophotographic device such as a photocopier.

Furthermore, the aromatic polyimide of the present invention has extremely high gas barrier property, and therefore it may be suitably used as a packaging material for foods, medicines, and the like, a packaging material for electronic devices such as display elements, and the like, a sealing material, a material for substrates, and a gas barrier material for hollow beads, and the like.

Best Mode for Carrying Out the Invention

The aromatic polyimide of the present invention comprises a repeating unit represented by the aforementioned general formula (1). In other words, the aromatic polyimide of the present invention is prepared from a tetracarboxylic acid component consisting essentially of 25 mol% to 97 mol%, preferably 30 mol% to 95 mol%, more preferably 40 mol% to 85 mol% of 3,3',4,4'-biphenyltetracarboxylic acid and 75 mol% to 3 mol%, preferably 70 mol% to 5 mol%, more preferably 60 mol% to 15 mol% of 4,4'-oxydiphthalic acid based on 100 mol% of the total amount of the tetracarboxylic acid component, and a diamine component consisting essentially of p-phenylenediamine.

Herein, tetracarboxylic acids include derivatives to be used as a tetracarboxylic acid component for a polyimide such as tetracarboxylic acids, dianhydrides thereof, and esters thereof. Meanwhile, diamines include derivatives to be used as a diamine component for a polyimide such as diamines, and diisocyanate. These components may comprise other tetracarboxylic acids or diamines, as long as the effect of the present invention would not be impaired, but each of these components generally comprises other tetracarboxylic acids or diamines in an amount of 10 mol% or less, preferably 5 mol% or less, more preferably 3 mol% or less.

Due to its specific chemical composition as described above, the aromatic polyimide of the present invention has extremely high stiffness and extremely high gas barrier property.

In the present invention, a breaking energy per unit volume at tensile break in the form of a film is used as one index of stiffness. The aromatic polyimide of the present invention has extremely high breaking energy per unit volume. In other words, the aromatic polyimide of the present invention is not easily broken when a force is exerted on it from the outside. Furthermore, in the present invention, a tensile elastic modulus, a tensile strength at break, and a tensile elongation at break are used as other indexes of stiffness. The aromatic polyimide of the present invention is particularly excellent in any of these mechanical properties as well. Such particularly excellent stiffness may be achieved by the specific chemical composition of the present invention. It may not be achieved when using another component as a tetracarboxylic acid component or a diamine component.

In addition, it is surprising that the aromatic polyimide of the present invention, which is an aromatic polyimide in which a segment derived from 3,3',4,4'-biphenyltetracarboxylic acid and p-phenylenediamine, and a segment derived from 4,4'-oxydiphthalic acid and p-phenylenediamine are copolymerized at the specific ratio, has higher stiffness than both an aromatic polyimide consisting of a segment derived from 3,3',4,4'-biphenyltetracarboxylic acid and p-phenylenediamine, and an aromatic polyimide consisting of a segment derived from 4,4'-oxydiphthalic acid and p-phenylenediamine. In the aromatic polyimide of the present invention, the aforementioned segments may be block-copolymerized or random-copolymerized.

The aromatic polyimide of the present invention has a tensile strength at break of 400 MPa or higher, preferably 450 MPa or higher, more preferably 500 MPa or higher, and a tensile elongation at break of 35 % or higher, preferably 40 % or higher, in the form of a film. An aromatic polyimide having such a high tensile strength at break and high tensile elongation at break may be suitably prepared when A in the general formula (1) consists of 25 mol% to 97 mol%, preferably 30 mol% to 95 mol%, more preferably 40 mol% to 85 mol% of the general formula (2) and 75 mol% to 3 mol%, preferably 70 mol% to 5 mol%, more preferably 60 mol% to 15 mol% of the general formula (3).

Furthermore, the aromatic polyimide of the present invention preferably has a tensile energy at break of 145 $MJ/m^3$ or higher, more preferably 150 $MJ/m^3$ or higher, in the form of a film. An aromatic polyimide having such a high tensile energy at break may be suitably prepared when A in the general formula (1) consists of 25 mol% to 97 mol%, preferably 30 mol% to 95 mol%, more preferably 30 mol% to 85 mol%, particularly preferably 40 mol% to 85 mol% of the general formula (2) and 75 mol% to 3 mol%, preferably 70 mol% to 5 mol%, more preferably 70 mol% to 15 mol%, particularly preferably 60 mol% to 15 mol% of the general formula (3).

As described above, the aromatic polyimide of the present invention has extremely high stiffness. Accordingly, it may be suitably used for parts for various precision instruments such as electrical and electronic devices, and photocopiers, for example, an intermediate transfer seamless belt, a fixing seamless belt, or a conveying seamless belt of an electrophotographic device such as a photocopier.

The seamless belt of the present invention is composed of the aromatic polyimide of the present invention, and may comprise other additive components as necessary. The seamless belt of the present invention may have another resin layer and/or a metal layer thereon.

A thickness of the seamless belt of the present invention may be appropriately selected depending on the intended use, and it may be generally from about 20 $\mu$m to about 200 $\mu$m.

The seamless belt of the present invention may be suitably produced by a conventionally known method, for example, by a rotational molding method, i.e., by forming a coating film of a polyamic acid solution composition (solution composition of the present invention) on a surface (inner side or outer side) of a cylindrical mold, which functions as a substrate, while rotating the mold; heating the film at a relatively low temperature to volatilize a solvent, thereby forming a self-supporting film (the film in a state of not flowing; the polymerization and partial imidization reaction, as well as the removal of the solvent, proceed.); and then heating the self-supporting film on the substrate, or alternatively, the self-supporting film which is peeled from the substrate, if necessary.

When the seamless belt is used for an intermediate transfer belt of a photocopier, a conductive material such as carbon black may be preferably added so that the seamless belt has a surface resistivity of $1 \times 10^{10}$ $\Omega/m^2$ to $1 \times 10^{14}$ $\Omega/m^2$. Meanwhile, when the seamless belt is used for a fixing belt, a filler such as silica, boron nitride and alumina may be preferably added, or a metal foil may be preferably laminated thereon so that higher thermal conductivity is imparted to the seamless belt.

Furthermore, the aromatic polyimide of the present invention has gas barrier property; specifically, a water vapor permeability (40˚C, 90%RH) of 0.04 g·mm/$m^2$ ·24hr or less, preferably 0.03 g·mm/$m^2$ ·24hr or less, in the form of a film. An aromatic polyimide having such a gas barrier property may be suitably prepared when A in the general formula (1) consists of 30 mol% to 85 mol%, preferably 40 mol% to 85 mol%, more preferably 40 mol% to 75 mol% of the general formula (2) and 70 mol% to 15 mol%, preferably 60 mol% to 15 mol%, more preferably 60 mol% to 25 mol% of the general formula (3).

The aromatic polyimide of the present invention has excellent gas barrier property against other gases such as oxygen gas, nitrogen gas and carbon dioxide gas, as well as water vapor. No conventional resin material may have such an excellent gas barrier property.

In addition, it is surprising that the aromatic polyimide of the present invention, which is an aromatic polyimide in which a segment derived from 3,3',4,4'-biphenyltetracarboxylic acid and p-phenylenediamine, and a segment derived from 4,4'-oxydiphthalic acid and p-phenylenediamine are copolymerized at the specific ratio, has higher gas barrier property than both an aromatic polyimide consisting of a segment derived from 3,3',4,4'-biphenyltetracarboxylic acid and p-phenylenediamine, and an aromatic polyimide consisting of a segment derived from 4,4'-oxydiphthalic acid and p-phenylenediamine. In the aromatic polyimide of the present invention, the aforementioned segments may be block-copolymerized or random-copolymerized.

As described above, the aromatic polyimide of the present invention has extremely high gas barrier property. Accordingly, it may be suitably used as, but not limited to, a packaging material for foods, medicines, and the like, a packaging material for electronic devices such as display elements, and the like, a sealing material, a material for substrates, and the like.

Furthermore, the aromatic polyimide of the present invention has both extremely high stiffness and extremely high gas barrier property. Accordingly, it may be suitably used for a polyimide hollow bead filled with a normal pressure to high pressure gas in the hollow, for example. The polyimide hollow bead of the present invention may not burst readily and the pressure in the hollow may not often decrease in a short time even when it is filled with a high pressure gas, because the polyimide has both extremely high stiffness and extremely high gas barrier property. The polyimide hollow bead of the present invention may have extremely high stability. Various gases may be suitably used to fill the polyimide hollow bead with, depending on the intended use, and inert gases, particularly nitrogen gas may be preferably used, for example.

The polyimide hollow bead of the present invention may be produced by a conventionally known method. For example, the following methods may be suitably adopted:

a method in which a thermally expandable particle containing an expanding agent in a resin is heated, thereby expanding it (for example, Japanese Kokoku Patent Publication No. S42-26525, Japanese Laid-open Patent Publication No. S60-19033, Japanese Laid-open Patent Publication No. 2006-213930, etc.),

a method in which a minute bubble as a core is generated in a resin solution, and a resin film is formed at the gas-liquid interface of the minute bubble (for example, Japanese Laid-open Patent Publication No. 2007-21315, etc.),

a method in which a gas and a resin solution are discharged and extruded into the form of a tube from a multiple-nozzle, while vibrating at high frequency, thereby forming a droplet of the resin containing a gas, and then the resin is solidified in a solidifying solution (for example, Japanese Laid-open Patent Publication No. H10-328556, Japanese Laid-open Patent Publication No. H06-55060, etc.), and

a method in which a microcapsule containing a liquid in a resin is provided, and then the liquid is removed from the microcapsule, thereby forming a hollow microcapsule (for example, US Patent No. 5,741,478, etc.).

An average particle size of the polyimide hollow bead of the present invention may be appropriately selected depending on the intended use, and it may be generally from about 100 nm to about 10 mm, preferably from about 1 μm to about 5 mm.

The polyimide hollow bead may be suitably used in various applications. For example, it may be filled into a flat tire so as to maintain the traveling performance of the tire; it may be added to a resin composition, for example, it may be added to an ink composition so as to improve transparency and the quality of image; and it may be added to a slurry building material composition such as a flooring material so as to achieve weight reduction and improve durability.

The aromatic polyimide of the present invention may be suitably produced by imidizing an aromatic polyamic acid represented by the aforementioned general formula (5).

The aromatic polyamic acid may be readily prepared by reacting a tetracarboxylic acid component comprising 25 mol% to 97 mol%, preferably 30 mol% to 95 mol%, more preferably 30 mol% to 85 mol%, particularly preferably 40 mol% to 85 mol% of 3,3',4,4'-biphenyltetracarboxylic acid and 75 mol% to 3 mol%, preferably 70 mol% to 5 mol%, more preferably 70 mol% to 15 mol%, particularly preferably 60 mol% to 15 mol% of 4,4'-oxydiphthalic acid with a diamine component comprising p-phenylenediamine as a main component under the conditions that an excessive imidization reaction may be suppressed.

A tetracarboxylic dianhydride is preferably used as a tetracarboxylic acid component and a diamine is preferably used as a diamine component because the reaction is readily carried out when using them. An aromatic polyamic acid represented by the general formula (5) may be readily prepared by reacting the given amounts of tetracarboxylic dianhydride and diamine in an organic solvent under the reaction conditions that an amic acid structure may be formed and an excessive imidization reaction may be suppressed, specifically, at a reaction temperature of 100˚C or lower, preferably 80˚C or lower, more preferably 70˚C or lower. Although the imidization reaction may partially proceed, an excessive imidization reaction needs to be suppressed so that the product can be homogeneously dissolved in the organic solvent. When the imidization reaction excessively proceeds, the product may be precipitated, and therefore an inhomogeneous composition may be prepared, that is, it may be difficult to obtain the aromatic polyimide of the present invention.

Alternatively, in the present invention, an aromatic polyamic acid represented by the general formula (5) may be obtained by preparing a polyamic acid solution by reacting the given amounts of 3,3',4,4'-biphenyltetracarboxylic acid and p-phenylenediamine in an organic solvent; preparing a polyamic acid solution separately by reacting the given amounts of 4,4'-oxydiphthalic acid and p-phenylenediamine in an organic solvent; and then mixing these polyamic acid solutions and, if necessary, reacting them.

In the present invention, it is important that the molar ratio of the tetracarboxylic acid component to the diamine component (tetracarboxylic acid component / diamine component) is substantially equimolar, specifically, 0.95 to 1.05, preferably 0.97 to 1.03. When the molar ratio is out of the above range, the polyimide obtained may be inferior in properties such as stiffness, and therefore it may be difficult to obtain the aromatic polyimide of the present invention.

Examples of the organic solvent to be used for the preparation of the aromatic polyamic acid of the present invention include amide solvents such as N,N-dimethylformamide, N,N-dimethylacetamide, N-methyl-2-pyrrolidone, and N-methylcaprolactam; solvents containing a sulfur atom such as dimethylsulfoxide, hexamethylsulfoformamide, dimethylsulfone, tetramethylenesulfone, and dimethyltetramethylenesulfone; phenol solvents such as cresol, phenol, and xylenol; diglyme solvents such as diethylene glycol dimethyl ether (diglyme), triethylene glycol dimethyl ether (triglyme), and tetraglyme; lactone solvents such as γ-butyrolactone; ketone solvents such as isophorone, cyclohexanone, and 3,3,5-trimethylcyclohexanone; other solvents such as pyridine, ethylene glycol, dioxane, and tetramethyl urea; and, as necessary, aromatic hydrocarbon solvents such as benzene, toluene, and xylene. These solvents may be used singly, or may be a mixture of two or more solvents.

The solution composition of the present invention is obtained by dissolving the aromatic polyamic acid represented by the general formula (5) thus obtained in an organic solvent.

The solution composition of the present invention may suitably contain, if necessary, an organic or inorganic filler such as silica, boron nitride, alumina and carbon black, an additive, an anti-foaming agent, a pigment, a dye, and the like.

The aromatic polyimide of the present invention may be suitably produced by applying the solution composition which is obtained by homogeneously dissolving the aromatic polyamic acid represented by the general formula (5) in an organic solvent (solution composition of the present invention) on a support; and then heating it to effect solvent removal, polymerization and imidization. In the heat treatment, the highest heating temperature may be preferably 275˚C or higher, more preferably 300˚C or higher, more preferably 325˚C or higher, particularly preferably 350˚C or higher. When the highest heating temperature is lower than 275˚C, the aromatic polyimide obtained may not have sufficiently high stiffness. When the highest heating temperature is 325˚C or higher, more preferably 350˚C or higher, further preferably 400˚C or higher, particularly preferably higher than 400˚C, in particular, the aromatic polyimide obtained may have extremely high stiffness.

The aromatic polyimide of the present invention may be suitably produced by applying the solution composition which is obtained by homogeneously dissolving the aromatic polyamic acid represented by the general formula (5) in an organic solvent (solution composition of the present invention) on a support; heating it at a temperature of 200˚C or lower to volatilize a solvent, thereby forming a self-supporting film (the film in a state of not flowing; the polymerization and partial imidization reaction, as well as the removal of the solvent, proceed.); and then heating the self-supporting film at a temperature of 275˚C or higher, more preferably 325˚C or higher, if necessary, while applying proper tension to the self-supporting film, after the self-supporting film is peeled off from the support.

The support to be used may be a belt base material for continuous production, electronic parts (the surface thereof), a cylindrical mold (the inner or outer surface thereof) which is commonly used for the production of a seamless belt, and the like. A seamless belt may be formed while rotating the cylindrical mold so as to generate appropriate centrifugal force.

The heat treatment for the production of a polyimide seamless belt or a polyimide hollow bead may be conducted in the same way as the heat treatment for the production of a polyimide film as described above.

Examples

The present invention will be more specifically described below with reference to the Examples. However, the present invention is not limited to the following Examples.

Abbreviations of compounds used in the following examples are as follows.

s-BPDA: 3,3',4,4'-biphenyltetracarboxylic dianhydride,
a-BPDA: 2,3',3,4'-biphenyltetracarboxylic dianhydride,
ODPA: 4,4'-oxydiphthalic dianhydride,
PMDA: pyromellitic dianhydride,
PPD: p-phenylenediamine,
ODA: 4,4'-diaminodiphenyl ether.

(Measurement of Tensile Energy at Break)

The tensile energy at break was measured in accordance with ASTM D882, using a tensile tester (RTC-1225A, manufactured by Orientec Co., Ltd.). The tensile energy at break was calculated based on "the method for the determination of tensile energy at break" in A2.1 of ASTM D882.

(Method for Measurement of Tensile Strength at Break)

The tensile strength at break was measured in accordance with ASTM D882, using a tensile tester (RTC-1225A, manufactured by Orientec Co., Ltd.).

(Method for Measurement of Tensile Elongation at Break)

The tensile elongation at break was measured in accordance with ASTM D882, using a tensile tester (RTC-1225A, manufactured by Orientec Co., Ltd.).

(Method for Measurement of Tensile Elastic Modulus)

The tensile elastic modulus was measured in accordance with ASTM D882, using a tensile tester (RTC-1225A, manufactured by Orientec Co., Ltd.).

(Inherent Viscosity of Solution Composition)

The inherent viscosity ($\eta_{inh}$) was determined as follows. The polyamic acid solution obtained was dissolved in N-methyl-2-pyrrolidone to prepare a homogeneous polyamic acid solution having a polyamic acid concentration of 0.5 g/100 ml solvent. And then, the solution viscosity of the resulting solution and the solvent was measured at 30°C, and the inherent viscosity ($\eta_{inh}$) was calculated by the following equation.

$$\text{Inherent Viscosity}\ (\eta_{inh}) = \frac{\ln\left(\text{Solution viscosity} \,/\, \text{Solvent viscosity}\right)}{\text{Concentration of Solution}}$$

(Solid Content Concentration)

The solid content concentration of the polyamic acid solution was determined as follows. The polyamic acid solution was dried at 350°C for 30 minutes. And then, the solid content concentration was calculated from its weight before drying (W1) and its weight after drying (W2) by the following equation.

$$\text{Solid Content Concentration (wt\%)} = \{(W1\text{-}W2) / W1\} \times 100$$

(Solution Viscosity) The solution viscosity was measured at 30°C using an E type viscometer, manufactured by Tokimec Inc.

(Measurement of Water Vapor Permeability)

The polyimide film was prepared from the polyamic acid solution. The water vapor permeability (permeation amount of water vapor per unit area and unit time) of the polyimide film obtained was measured for water vapor at 40°C and 90%RH in accordance with JIS K7129B. And then, the measured value was converted into the water vapor permeability per unit thickness by using the thickness of the polyimide film.

(Measurement of Nitrogen Permeability Coefficient)

The nitrogen permeability coefficient of the polyimide film prepared from the polyamic acid solution was measured at 23°C in accordance with JIS K7126-1 GC.

(Measurement of Oxygen Permeability Coefficient)

The oxygen permeability coefficient of the polyimide film prepared from the polyamic acid solution was measured at 23°C in accordance with JIS K7126-1B.

(Measurement of Carbon Dioxide Gas Permeability Coefficient)

The carbon dioxide gas permeability coefficient of the polyimide film prepared from the polyamic acid solution was measured at 23°C in accordance with Permatran method, using a PERMATRAN C-IV type (MOCON, Inc.).

(Solution Stability of Polyamic Acid Solution Composition)

The solution stability of the polyamic acid solution was evaluated from the change in solution viscosity of the polyamic acid solution having a monomer concentration of 20 %. The solution viscosity was measured at 30°C using an E type viscometer. Specifically, the rate of change in solution viscosity was calculated from the solution viscosity of the polyamic acid solution immediately after the preparation (P1) and the solution viscosity of the polyamic acid solution after being stored in an atmosphere at a temperature of 5°C for 90 days (P2) by the following equation. A polyamic acid solution of which the rate of change in solution viscosity was within the range of ±10 % was marked by ○, while a polyamic acid solution of which the rate of change in solution viscosity was out of the range of ±10 % was marked by ×.
$$\text{Rate of Change (\%)} = \{(P2\text{-}P1) / P1\} \times 100$$

(Example 1)

In a 500 ml-volume glass reactor equipped with a stirrer and a nitrogen gas inlet/outlet tube was placed the given amount of N-methyl-2-pyrrolidone as a solvent. 26.77 g (0.248 mol) of PPD, 65.55 g (0.223 mol) of s-BPDA and 7.68 g (0.025 mol) of ODPA were added to the solvent, and the resulting mixture was stirred at 50°C for 10 hours, to obtain a polyamic acid solution with the solid content concentration of 18. 7 wt%, the solution viscosity of 97.5 Pa·s and the inherent viscosity of 1.13.
The solution stability of the polyamic acid solution composition thus obtained was evaluated as o.
The polyamic acid solution composition was applied on a glass plate, which is a support, by means of a bar coater, and the resulting film was defoamed and pre-dried at 25°C for 30 minutes, at 80°C for 30 minutes, at 100°C for 20 minutes and at 130°C for 60 minutes under reduced pressure. And then, the dried film was peeled off from the glass plate, and set on a pin tenter. Subsequently, the film was heated at 100°C, 150°C, 200°C, 250°C and 400°C for 3 minutes

each in a hot air dryer under normal pressure, to obtain a polyimide film having a thickness of 50 μm.
The properties of the polyimide film obtained are shown in Table 1.

(Example 2)

A polyimide film was obtained in the same way as in Example 1, except that 26.67 g (0.246 mol) of PPD, 58.03 g (0.197 mol) of s-BPDA and 15.30 g (0.049 mol) of ODPA were used.
The properties of the polyimide film obtained are shown in Table 1.

(Example 3)

A polyimide film was obtained in the same way as in Example 1, except that 26.56 g (0.246 mol) of PPD, 50.58 g (0.172 mol) of s-BPDA and 22.86 g (0.074 mol) of ODPA were used.
The properties of the polyimide film obtained are shown in Table 1.

(Example 4)

A polyimide film was obtained in the same way as in Example 1, except that 26.46 g (0.245 mol) of PPD, 43.19 g (0.147 mol) of s-BPDA and 30.36 g (0.098 mol) of ODPA were used.
The properties of the polyimide film obtained are shown in Table 1.

(Example 5)

A polyimide film was obtained in the same way as in Example 1, except that 26.36 g (0.244 mol) of PPD, 35.85 g (0.122 mol) of s-BPDA and 37.80 g (0.122 mol) of ODPA were used.
The properties of the polyimide film obtained are shown in Table 1.

(Example 6)

A polyimide film was obtained in the same way as in Example 1, except that 26.15 g (0.242 mol) of PPD, 21.34 g (0.073 mol) of s-BPDA and 52.51 g (0.169 mol) of ODPA were used.
The properties of the polyimide film obtained are shown in Table 1.

(Example 7)

In a 500 ml-volume glass reactor equipped with a stirrer and a nitrogen gas inlet/outlet tube was placed the given amount of N-methyl-2-pyrrolidone as a solvent. 26.88 g (0.249 mol) of PPD and 73.12 g (0.249 mol) of s-BPDA were added to the solvent, and the resulting mixture was stirred at 50˚C for 10 hours, to obtain a polyamic acid solution composition (A) with the solid content concentration of 18.4 %, the solution viscosity of 100.0 Pa·s and the inherent viscosity of 1.15.
In a 500 ml-volume glass reactor equipped with a stirrer and a nitrogen gas inlet/outlet tube was placed the given amount of N-methyl-2-pyrrolidone as a solvent. 25.85 g (0.239 mol) of PPD and 74.15 g (0.239 mol) of ODPA were added to the solvent, and the resulting mixture was stirred at 50˚C for 10 hours, to obtain a polyamic acid solution composition (B) with the solid content concentration of 18.5 %, the solution viscosity of 105.0 Pa·s and the inherent viscosity of 1.31.
The polyamic acid solution compositions (A) and (B) were mixed at a weight ratio of 95:5. After mixing, the polyamic acid in the solution composition comprises s-BPDA, ODPA and PPD at a molar ratio (mol%) of s-BPDA/ODPA/PPD = 94.93/5.07/100.
The polyamic acid solution composition was applied on a glass plate, which is a support, by means of a bar coater, and the resulting film was defoamed and pre-dried at 25˚C for 30 minutes, at 80˚C for 30 minutes, at 100˚C for 20 minutes and at 130˚C for 60 minutes under reduced pressure. And then, the dried film was peeled off from the glass plate, and set on a pin tenter. Subsequently, the film was heated at 100˚C, 150˚C, 200˚C, 250˚C and 400˚C for 3 minutes each in a hot air dryer under normal pressure, to obtain a polyimide film having a thickness of 50 μm.
The properties of the polyimide film obtained are shown in Table 1.

(Example 8)

A polyimide film was obtained in the same way as in Example 7, except that the polyamic acid solution compositions (A) and (B) were mixed at a weight ratio of 70:30.
The properties of the polyimide film obtained are shown in Table 1.

(Example 9)

A polyimide film was obtained in the same way as in Example 7, except that the polyamic acid solution compositions (A) and (B) were mixed at a weight ratio of 50:50.
The properties of the polyimide film obtained are shown in Table 1.

(Example 10)

A polyimide film was obtained in the same way as in Example 7, except that the polyamic acid solution compositions (A) and (B) were mixed at a weight ratio of 30:70.
The properties of the polyimide film obtained are shown in Table 1.

(Example 11)

A polyimide film was obtained in the same way as in Example 1, except that the polyamic acid solution composition was prepared in the same way as in Example 3 and used, and the highest heating temperature was changed as shown in Table 2. And then, the tensile strength at break, the tensile elongation at break, and the tensile elastic modulus of the polyimide film obtained were measured.
The results are shown in Table 2.

(Example 12)

Production of Seamless Belt

To 30.0 g of the polyamic acid solution composition prepared in the same way as in Example 3 was added 25.0 g of N-methyl-2-pyrrolidone. Then, the resulting mixture was fully mixed, to obtain a dilute solution. The polyamic acid solution composition thus obtained was injected into an inner surface of a cylindrical mold having an inside diameter of 250 mm and a width of 140 mm, and was uniformly applied thereon by means of a scraper while rotating the mold at 40 rpm. Subsequently, the mold was rotated at 200 rpm for 1 minute at room temperature to flow-cast the polyamic acid solution composition in a uniform thickness thereon, and then, while rotating the mold at 200 rpm, the mold surface temperature was raised to 120°C and kept at 120°C for 30 minutes by means of a far-infrared ceramic heater in a nitrogen atmosphere. And then, the mold was transferred into a hot air dryer, and heated at 120°C for 5 minutes, at 150°C for 5 minutes, at 190°C for 80 minutes, at 250°C for 10 minutes and at 400°C for 10 minutes. After cooling down, a seamless belt was taken out from the mold. The seamless belt was uniform without foaming (expansion) and had a thickness of 40 μm.

(Comparative Example 1)

A polyimide film was obtained in the same way as in Example 1, except that 26.88 g (0.249 mol) of PPD and 73.12 g (0.249 mol) of s-BPDA were used.
The properties of the polyimide film obtained are shown in Table 3.
This example corresponds to the polyamic acid solution composition (A) in Example 7 as described above.

(Comparative Example 2)

A polyimide film was obtained in the same way as in Example 1, except that 25.85 g (0.239 mol) of PPD and 74.15 g (0.239 mol) of ODPA were used.
The properties of the polyimide film obtained are shown in Table 3.
This example corresponds to the polyamic acid solution composition (B) in Example 7 as described above.

(Comparative Example 3)

A polyimide film was obtained in the same way as in Example 1, except that 25.95 g (0.240 mol) af PPD, 7.06 g (0.024 mol) of s-BPDA and 66.99 g (0.216 mol) of ODPA were used.
The properties of the polyimide film obtained are shown in Table 3.

(Comparative Example 4)

A polyimide film was obtained in the same way as in Example 1, except that 26.56 g (0.246 mol) of PPD, 50.58 g (0.172 mol) of a-BPDA and 22.86 g (0.074 mol) of ODPA were used.
The properties of the polyimide film obtained are shown in Table 3.

(Comparative Example 5)

A polyimide film was obtained in the same way as in Example 1, except that 30.56 g (0.283 mol) of PPD, 43.14 g (0.198 mol) of PMDA and 26.30 g (0.085 mol) of ODPA were used.
The properties of the polyimide film obtained are shown in Table 3.

(Comparative Example 6)

A polyimide film was obtained in the same way as in Example 1, except that 40.11 g (0.200 mol) of ODA, 41.25 g (0.140 mol) of s-BPDA and 18.64 g (0.060 mol) of ODPA were used.
The properties of the polyimide film obtained are shown in Table 3.

(Comparative Example 7)

The effects of the end-capping agent and the heating temperature on the properties of the polyimide were confirmed by the following Example.
Specifically, in accordance with Example 6 of Patent Document 3, 16.34 g of p-phenylenediamine was dissolved in 348 g of dimethylacetamide, and then 33.10 g of s-BPDA, 11.63 g of ODPA and 0.33 g of phthalic acid were added to the resulting solution and reacted.
The polyamic acid solution thus obtained had the inherent viscosity of 1.60, the solid content concentration of 13.9 % and the solution viscosity at 30˚C of 23.8 Pa·s.
Using this polyamic acid solution composition, a polyimide film was obtained in the same way as in Example 6 of Patent Document 3, or Example 1 of the specification (the highest heating temperature was 300˚C or 400˚C).
The properties of the polyimide film obtained are shown in Table 4.
As seen from Table 4, in the case where the end-capping agent was used, all the polyimide films obtained had lower tensile strength at break and lower tensile elongation at break, even when the highest heating temperature was higher.
[Table 1]

| | | Example 1 | Example 2 | Example 3 | Example 4 | Example 5 | Example 6 |
|---|---|---|---|---|---|---|---|
| Composition of polyamic acid | | | | | | | |
| Acid component | s-BPDA (mol%) | 90 | 80 | 70 | 60 | 50 | 30 |
| | ODPA (mol%) | 10 | 20 | 30 | 40 | 50 | 70 |
| Diamine component | PPD (mol%) | 100 | 100 | 100 | 100 | 100 | 100 |
| Polyamic acid solution composition | | | | | | | |
| | Inherent viscosity | 1.13 | 1.13 | 1.16 | 1.15 | 1.18 | 1.22 |
| | Solid content concentration (mass %) | 18.7 | 18.4 | 18.4 | 18.7 | 18.3 | 18.2 |
| | Solution viscosity (Pa·s) | 97.5 | 96.3 | 101.3 | 102.5 | 106.3 | 97.5 |
| | Solution stability | ○ | ○ | ○ | ○ | ○ | ○ |
| Polyimide film | | | | | | | |
| | Film thickness (μm) | 50 | 50 | 50 | 50 | 50 | 50 |
| | Water vapor permeability ($g·mm/m^2·24hr$) | 0.048 | Not measured | 0.018 | Not measured | 0.012 | 0.038 |
| | Nitrogen permeability coefficient ($cm^3·mm/m^2·24hr·atm$) | 0.014 | | 0.014 | | 0.018 | 0.009 |
| | Oxygen permeability coefficient ($cm^3·mm/m^2·24hr·atm$) | 0.040 | | 0.020 | | 0.030 | 0.030 |
| | Carbon dioxide gas permeability coefficient ($cm^3·mm/m^2·24hr·atm$) | 0.130 | | Not measured | | 0.070 | Not measured |
| | Tensile strength (MPa) | 531 | 556 | 621 | 504 | 517 | 462 |
| | Elongation (%) | 38 | 47 | 51 | 53 | 49 | 46 |
| | Tensile elastic modulus (MPa) | 8.9 | 8.3 | 8.4 | 8.2 | 8.1 | 7.9 |
| | Energy at break ($MJ/m^3$) | 148 | 183 | 206 | 189 | 175 | 165 |

| | | Example 7 | Example 8 | Example 9 | Example 10 |
|---|---|---|---|---|---|
| Composition of polyamic acid | | | | | |
| Acid component | s-BPDA (mol%) | 94.93 | 69.71 | 49.65 | 29.71 |
| | ODPA (mol%) | 5.07 | 30.29 | 50.35 | 70.29 |
| Diamine component | PPD (mol%) | 100 | 100 | 100 | 100 |
| Polyamic acid solution composition | | | | | |
| | Inherent viscosity | Not measured | | | |
| | Solid content concentration (mass %) | | | | |
| | Solution viscosity (Pa·s) | | | | |
| | Solution stability | | | | |
| Polyimide film | | | | | |
| | Film thickness (μm) | 50 | 50 | 50 | 50 |
| | Water vapor permeability ($g \cdot mm/m^2 \cdot 24hr$) | Not measured | | | |
| | Nitrogen permeability coefficient ($cm^3 \cdot mm/m^2 \cdot 24hr \cdot atm$) | | | | |
| | Oxygen permeability coefficient ($cm^3 \cdot mm/m^2 \cdot 24hr \cdot atm$) | | | | |
| | Carbon dioxide gas permeability coefficient ($cm^3 \cdot mm/m^2 \cdot 24hr \cdot atm$) | | | | |
| | Tensile strength (MPa) | 482 | 539 | 451 | 402 |
| | Elongation (%) | 44 | 49 | 50 | 51 |
| | Tensile elastic modulus (MPa) | 9.2 | 8.9 | 7.6 | 7.8 |
| | Energy at break ($MJ/m^3$) | 156 | 160 | 160 | 160 |

[Table 2]

| Heat treatment conditions | Tensile strength at break (MPa) | Tensile elongation at break (%) | Tensile elastic modulus (GPa) | Remarks |
|---|---|---|---|---|
| Only pre-drying at 130˚C | 135 | 61 | 2.8 | |
| 150˚C for 3 minutes after set on a pin tenter | 168 | 51 | 3.7 | |
| 150˚C, 200˚C for 3 minutes each after set on a pin tenter | 294 | 38 | 5.5 | |
| 150˚C, 200˚C, 250˚C for 3 minutes each after set on a pin tenter | 406 | 50 | 6.5 | |
| 150˚C, 200˚C, 250˚C, 300˚C for 3 minutes each after set on a pin tenter | 520 | 55 | 7.8 | |
| 150˚C, 200˚C, 250˚C, 300˚C, 350˚C for 3 minutes each after set on a pin tenter | 551 | 60 | 8.0 | |
| 150˚C, 200˚C, 250˚C, 300˚C, 350˚C, 400˚C for 3 minutes each after set on a pin tenter | 583 | 54 | 8.4 | Example 3 |
| 150˚C, 200˚C, 250˚C, 300˚C, 350˚C, 400˚C, 450˚C for 3 minutes each after set on a pin tenter | 578 | 51 | 8.3 | |
| 150˚C, 200˚C, 250˚C, 300˚C, 350˚C, 400˚C, 450˚C, 500˚C for 3 minutes each after set on a pin tenter | 436 | 27 | 8.5 | |

[Table 3]

| | | Comparative Example 1 | Comparative Example 2 | Comparative Example 3 | Comparative Example 4 | Comparative Example 5 | Comparative Example 6 |
|---|---|---|---|---|---|---|---|
| Composition of polyamic acid | | | | | | | |
| Acid component | s-BPDA (mol%) | 100 | | 10 | | | 70 |
| | a-BPDA (mol%) | | | | 70 | | |
| | ODPA (mol%) | | 100 | 90 | 30 | 30 | 30 |
| | PMDA (mol%) | | | | | 70 | |
| Diamine component | PPD (mol%) | 100 | 100 | 100 | 100 | 100 | |
| | ODA (mol%) | | | | | | 100 |
| Polyamic acid solution composition | | | | | | | |
| | Inherent viscosity | 1.15 | 1.31 | 1.30 | 1.13 | 1.04 | 1.31 |
| | Solid content concentration (mass %) | 18.4 | 13.9 | 18.5 | 18.6 | 18.1 | 18.4 |
| | Solution viscosity (Pa·s) | 100.0 | 105.0 | 108.8 | 106.3 | 95.0 | 107.5 |
| | Solution stability | ○ | × | × | × | × | ○ |
| Polyimide film | | | | | | | |

(continued)

| | | Comparative Example 1 | Comparative Example 2 | Comparative Example 3 | Comparative Example 4 | Comparative Example 5 | Comparative Example 6 |
|---|---|---|---|---|---|---|---|
| | Film thickness (μm) | 50 | 50 | 50 | 50 | 50 | 50 |
| | Water vapor permeability (g·mm/$m^2$·24hr) | 0.049 | 0.100 | 0.062 | Not measured | Unable to measure because the film was extremely fragile | Not measured |
| | Tensile strength (MPa) | 429 | 260 | 299 | 122 | Unable to measure because the film was extremely fragile | 125 |
| | Elongation (%) | 27 | 47 | 53 | 39 | Unable to measure because the film was extremely fragile | 97 |
| | Tensile elastic modulus (MPa) | 7.1 | 6.3 | 6.7 | 3.3 | Unable to measure because the film was extremely fragile | 3.3 |
| | Energy at break ($MJ/m^3$) | 137 | 77 | 114 | Not measured | Unable to measure because the film was extremely fragile | Not measured |

[Table 4]

| Heat treatment conditions | Tensile strength at break (MPa) | Tensile elongation at break (%) | Tensile elastic modulus (GPa) |
|---|---|---|---|
| In accordance with Example 6 of Patent Document 3 Highest heating temperature of 300˚C | 222 | 7 | 7.3 |
| In accordance with Example 1 of the Specification Highest heating temperature of 300˚C | 241 | 12 | 7.4 |
| In accordance with Example 1 of the Specification Highest heating temperature of 400˚C | 361 | 32 | 8.3 |

Industrial Applicability

According to the present invention, there may be provided an aromatic polyimide of the specific chemical composition which has extremely high stiffness and extremely high gas barrier property, and a process for producing the aromatic polyimide. The aromatic polyimide of the present invention has extremely high stiffness, and therefore it may be suitably used for parts for various precision instruments such as electrical and electronic devices, and photocopiers, for example, an intermediate transfer seamless belt, a fixing seamless belt, or a conveying seamless belt of an electrophotographic device such as a photocopier. Furthermore, the aromatic polyimide of the present invention has extremely high gas barrier property, and therefore it may be suitably used as a packaging material for foods, medicines, and the like, a packaging material for electronic devices such as display elements, and the like, a sealing material, a material for substrates, and a material for hollow beads, and the like. Furthermore, the aromatic polyimide of the present invention has both extremely high stiffness and extremely high gas barrier property, and therefore it may be particularly suitably used for a polyimide hollow bead filled with a high pressure gas such as nitrogen gas, for example.

## Claims

1. An aromatic polyimide having a tensile strength at break of 400 MPa or higher and a tensile elongation at break of 35 % or higher in the form of a film, and comprising a repeating unit represented by the following general formula (1):

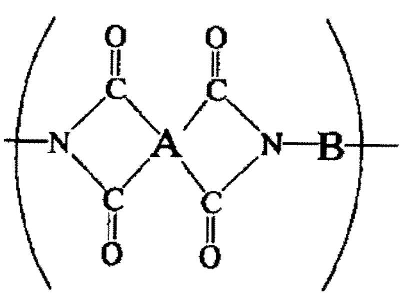

General Formula (1)

wherein 25 mol% to 97 mol% of A is a tetravalent unit represented by the following general formula (2) and 75 mol% to 3 mol% of A is a tetravalent unit represented by the following general formula (3); and

B is a bivalent unit represented by the following general formula (4).

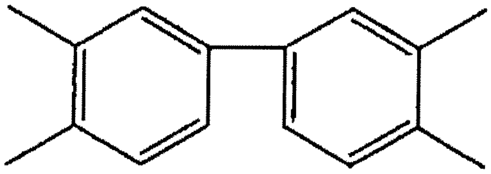

General Formula (2)

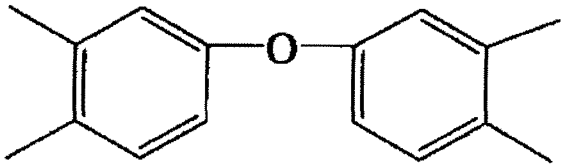

General Formula (3)

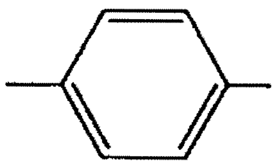

General Formula (4)

2. The aromatic polyimide according to claim 1, having a tensile strength at break of 500 MPa or higher and a tensile elongation at break of 40 % or higher in the form of a film.

3. The aromatic polyimide according to any of claims 1 to 2, having a tensile energy at break of 145 $MJ/m^3$ or higher in the form of a film.

4. The aromatic polyimide according to any of claims 1 to 3, having gas barrier property, i.e., water vapor permeability (40˚C, 90%RH) of 0.04 $g\cdot mm/m^2\cdot 24hr$ or less in the form of a film.

5. A process for producing an aromatic polyimide, comprising a step of:

heating an aromatic polyamic acid comprising a repeating unit represented by the following general formula (5) at a temperature of 325˚C or higher,

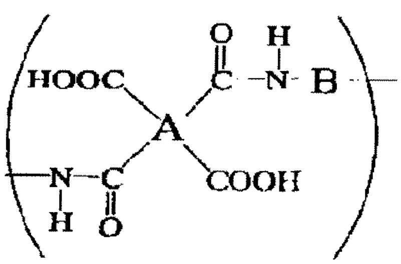

General Formula (5)

wherein 25 mol% to 97 mol% of A is a tetravalent unit represented by the above general formula (2) and 75 mol% to 3 mol% of A is a tetravalent unit represented by the above general formula (3); and
B is a bivalent unit represented by the above general formula (4).

6. A solution composition obtained by dissolving an aromatic polyamic acid comprising a repeating unit represented by the above general formula (5) in an organic solvent.

7. A seamless belt composed mainly of an aromatic polyimide according to any of claims 1 to 3.

8. The seamless belt according to claim 7, which is used as an intermediate transfer seamless belt, a fixing seamless belt, or a conveying seamless belt of an electrophotographic device.

9. A packaging material or a sealing material composed mainly of an aromatic polyimide according to claim 4.

10. A polyimide hollow bead composed mainly of an aromatic polyimide according to claim 4.

11. The polyimide hollow bead according to claim 10, which is filled with a high pressure gas.

12. The polyimide hollow bead according to claim 10, which is filled with nitrogen gas.

**INTERNATIONAL SEARCH REPORT**

International application No.
PCT/JP2008/056423

A. CLASSIFICATION OF SUBJECT MATTER
*C08G73/10*(2006.01)i, *B65G15/30*(2006.01)i, *G03G15/16*(2006.01)i, *G03G15/20*(2006.01)i, *H01L23/29*(2006.01)i, *H01L23/31*(2006.01)i

According to International Patent Classification (IPC) or to both national classification and IPC

B. FIELDS SEARCHED

Minimum documentation searched (classification system followed by classification symbols)
C08G73/10, B65G15/30, G03G15/16, G03G15/20, H01L23/29, H01L23/31

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)
CA(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>Y | JP 11-228715 A (Kaneka Corp.),<br>24 August, 1999 (24.08.99),<br>Claims; Par. No. [0048]; example 2<br>(Family: none) | 1-6<br>7-12 |
| X<br>Y | JP 2001-228301 A (Hitachi Chemical Co., Ltd.),<br>24 August, 2001 (24.08.01),<br>Claims; Par. No. [0031]; example 8<br>(Family: none) | 1-6<br>7-12 |
| Y | JP 2006-301196 A (Nitto Denko Corp.),<br>02 November, 2006 (02.11.06),<br>Claims; Par. Nos. [0023] to [0027], [0050]<br>(Family: none) | 7,8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 16 May, 2008 (16.05.08) | 03 June, 2008 (03.06.08) |
| Name and mailing address of the ISA/<br>Japanese Patent Office<br>Facsimile No. | Authorized officer<br><br>Telephone No. |

Form PCT/ISA/210 (second sheet) (April 2007)

**INTERNATIONAL SEARCH REPORT**

International application No.
PCT/JP2008/056423

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2006-321219 A (Toyobo Co., Ltd.), 30 November, 2006 (30.11.06), Scope of Claims; Claim 11; Par. Nos. [0013] to [0015] & WO 2006/114901 A1 | 9 |
| Y | JP 2002-503288 A (The United States of America), 29 January, 2002 (29.01.02), Claims; examples & WO 2000/071604 A1 & EP 1114079 A & US 5994418 A & US 6084000 A & US 5994418 A | 10-12 |
| A | JP 2006-323081 A (Nitto Denko Corp.), 30 November, 2006 (30.11.06), Claims; full text (Family: none) | 1-12 |
| A | JP 2004-255845 A (Du Pont-Toray Co., Ltd.), 16 September, 2004 (16.09.04), Claims; full text (Family: none) | 1-12 |
| A | JP 2007-069818 A (Bridgestone Corp.), 22 March, 2007 (22.03.07), Claims; full text (Family: none) | 1-12 |

Form PCT/ISA/210 (continuation of second sheet) (April 2007)

**INTERNATIONAL SEARCH REPORT**

International application No.
PCT/JP2008/056423

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:
See extra sheet.

1. ☐ As all required additional search fees were timely paid by the applicant, this international search report covers all searchable claims.
2. ☒ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** the
☐ The additional search fees were accompanied by the applicant's protest and, where applicable, payment of a protest fee.
☐ The additional search fees were accompanied by the applicant's protest but the applicable protest fee was not paid within the time limit specified in the invitation.
☐ No protest accompanied the payment of additional search fees.

Form PCT/ISA/210 (continuation of first sheet (2)) (April 2007)

**INTERNATIONAL SEARCH REPORT**

International application No. PCT/JP2008/056423

Continuation of Box No.III of continuation of first sheet(2)

Claim 1 relates to an aromatic polyimide which has a repeating unit represented by the chemical formula (1) and enables to form a film having properties including a tensile strength of 400 Mpa or more. Claims 5 and 6 relate to a process for producing an aromatic polyimide by heat-treating a polyamic acid having a repeating unit represented by the chemical formula (5), and a solution composition prepared by dissolving the polyamic acid, respectively.

However, Document 1 (JP 11-228715 A) and Document 2 (JP 2001-228301 A) disclose a solution of a polyimide having the same structural formula as the formula (1) of the present invention or a polyamic acid which is a precursor of the polyimide (corresponding to the formula (5) of the present invention), and a process for curing the solution.

Documents 1 and 2 do not disclose clearly about the tensile strength of or the like the polyimide. However, the invention of claim 1 relates to a compound, and therefore the polyimide represented by the formula (1) appears to be defined in these documents, regardless of its properties or the like.

Thus, claims 1, 5 and 6 describe a polyimide and a polyamic acid having the similar structures as those disclosed in Documents 1 and 2, therefore the technical feature of claims 1, 5 and 6 cannot be regarded as a "special technical feature" in the meaning within PCT Rule 13.2, second sentence.

Consequently, the present international application includes the following five inventions.

1st invention: a process for production of an aromatic polyimide using a polyamic acid having a repeating unit represented by the formula (5), and a solution of the polyamic acid (inventions of claims 5 and 6);
2nd invention: a seamless belt (inventions of claims 1-3, 7 and 8);
3rd invention: a packaging material (inventions of claims 1-4 and 9);
4th invention: a sealing material (inventions of claims 1-4 and 9); and
5th invention: a polyimide hollow bead (inventions of claims 1-4 and 10-12).

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006307114 A
- JP 2004255845 A
- JP 3157428 A
- JP 2003089125 A
- JP 2007240845 A
- JP 2007069818 A
- JP S4226525 B
- JP S6019033 B
- JP 2006213930 A
- JP 2007021315 A
- JP H10328556 B
- JP H0655060 B
- US 5741478 A